# EUROPÄISCHE PATENTANMELDUNG

(11) **EP 4 191 265 A1**
(43) Veröffentlichungstag der Anmeldung: **07.06.2023**
(21) Anmeldenummer: 21211759.2
(22) Anmeldetag: 01.12.2021
(51) Int. Cl.: G01R 31/42, G01R 31/34

(54) **TESTANORDNUNG ZUM TEST EINES LEISTUNGSELEKTRONISCHEN STEUERGERÄTS UND LEISTUNGSELEKTRONIK-MODUL FÜR EINE SOLCHE TESTANORDNUNG**

(71) Anmelder: dSPACE GmbH, 33102 Paderborn (DE)
(72) Erfinder: Bracker, Jörg, 33102 Paderborn (DE); Epping, Daniel, 33102 Paderborn (DE)

(57) **Zusammenfassung**

Dargestellt und beschrieben ist eine Testanordnung (1) zum Test eines leistungselektronischen Steuergeräts (2), wobei das Steuergerät (2) Speiseanschlüsse (3) zur Energiespeisung und Lastanschlüsse (4) zur Ansteuerung einer elektrischen Last aufweist, mit einer Mehrzahl von Leistungselektronik-Modulen (5), wobei jedes Leistungselektronik-Modul (5) Speiseanschlüsse (6) zur Energiespeisung, wenigstens einen Lastanschluss (7) zur Bereitstellung wenigstens einer elektrischer Anschlussgröße, eine Versorgungsschaltung zur Bereitstellung elektrischer Steuerspannungen, eine Auswahlschaltung (10) mit Leistungsschaltern (11) zur Aufschaltung einer der Steuerspannungen auf den Lastanschluss (7) des Leistungselektronik-Moduls (5) und eine Schnittstelle (12) zur Ansteuerung der Leistungsschalter (11) aufweist, wobei im einsatzfähigen Zustand der Testanordnung (1) die Speiseanschlüsse (3) und/oder die Lastanschlüsse (4) des Steuergeräts (2) jeweils mit dem Lastanschluss (7) eines Leistungselektronik-Moduls (5) zur Bereitstellung einer gewünschten elektrischen Anschlussgröße an den Speiseanschlüssen (3) und/oder den Lastanschlüssen (4) des Steuergeräts (2) verbunden sind und wobei die Speiseanschlüsse (6) der Leistungselektronik-Module (5) über ein elektrisches Zwischennetz (13) miteinander verbunden sind.

Die Einbindung von wechselstromgespeisten Komponenten in die Testanordnung wird dadurch vereinfacht, dass die Speiseanschlüsse (6) der Leistungselektronik-Module als Wechselstrom-Speiseanschlüsse (6~) ausgelegt sind und das elektrische Zwischennetz (13) als Wechselstrom-Zwischennetz (13~) ausgelegt ist und dass die Versorgungsschaltung als eine Mehrphasenschaltung (8) zur Bereitstellung mehrerer Phasenspannungen auf mehreren Phasenleitern (9) ausgebildet ist, wobei die Auswahlschaltung (10) mit den Leistungsschaltern (11) zur Verbindung eines Phasenleiters (9) mit dem Lastanschluss (7) des Leistungselektronik-Moduls (5) ausgebildet ist.

## Beschreibung

Die Erfindung betrifft eine Testanordnung zum Test eines leistungselektronischen Steuergeräts, wobei das Steuergerät Speiseanschlüsse zur Energiespeisung und Lastanschlüsse zur Ansteuerung einer elektrischen Last aufweist, mit einer Mehrzahl von Leistungselektronik-Modulen, wobei jedes Leistungselektronik-Modul Speiseanschlüsse zur Energiespeisung, wenigstens einen Lastanschluss zur Bereitstellung wenigstens einer elektrischer Anschlussgröße, eine Versorgungsschaltung zur Bereitstellung elektrischer Steuerspannungen, eine Auswahlschaltung mit Leistungsschaltern zur Aufschaltung einer der Steuerspannungen auf den Lastanschluss des Leistungselektronik-Moduls und eine Schnittstelle zur Ansteuerung der Leistungsschalter aufweist, wobei im einsatzfähigen Zustand der Testanordnung die Speiseanschlüsse und/oder die Lastanschlüsse des Steuergeräts jeweils mit dem Lastanschluss eines Leistungselektronik-Moduls zur Bereitstellung einer gewünschten elektrischen Anschlussgröße an den Speiseanschlüssen und den Lastanschlüssen des Steuergeräts verbunden sind und wobei die Speiseanschlüsse der Leistungselektronik-Module über ein elektrisches Zwischennetz miteinander verbunden sind. Darüber hinaus betrifft die Erfindung auch ein Leistungselektronik-Modul für eine solche Testanordnung.

Testanordnungen der vorgenannten Art sind aus dem Stand der Technik bekannt und dienen dem Test von leistungselektronischen Steuergeräten wie sie in ganz unterschiedlichen Bereichen der Technik eingesetzt werden, beispielsweise im automotiven Bereich, in der Luft- und Raumfahrt, aber auch in industriellen wie zum Beispiel prozesstechnischen Anwendungen. Das leistungselektronische Steuergerät ist dazu ausgelegt, elektrische Lasten anzusteuern, wobei es auf die absolute Höhe der zu beherrschenden elektrischen Leistungen nicht ankommt. Es ist möglich, dass lediglich Leistungen von einigen Watt gehandhabt werden müssen, es kann aber auch sein, dass Leistungen im Bereich von einigen 100 kW (oder mehr) gesteuert werden müssen.

Ein typisches Beispiel für ein leistungselektronisches Steuergerät ist im automotiven Bereich ein Motorsteuergerät für einen elektrischen Motor. Im realen Anwendungsfall, also nicht im Test mit der Testanordnung, wird das Motorsteuergerät über seine Speiseanschlüsse üblicherweise mittels einer Gleichstromquelle gespeist, und die Lastanschlüsse des Motorsteuergeräts werden mit den entsprechenden Speiseanschlüssen des Motors verbunden. Bei den Gleichspannungsquellen handelt es sich beispielsweise um Batterien. Je nachdem, ob der angeschlossene elektrische Motor motorisch oder generatorisch betrieben wird, kann der Energiefluss durch das leistungselektronische Steuergerät von seinen Speiseanschlüssen zu den Lastanschlüssen erfolgen, aber auch umgekehrt von den Lastanschlüssen zu den Speiseanschlüssen.

Bei der hier betrachteten Testanordnung wird die Umgebung des zu testenden leistungselektronischen Steuergeräts mit der Testanordnung zumindest teilweise leistungselektronisch simuliert, es wird also kein tatsächlicher Motor an die Lastanschlüsse des leistungselektronischen Steuergeräts angeschlossen, sondern entsprechende Leistungselektronik-Module; der Anwendungsfall wird als Hardware-in-the-Loop-Simulation (HIL-Simulation) bezeichnet. Meist werden auch an die Speiseanschlüsse des leistungselektronischen Steuergeräts entsprechende Leistungselektronik-Module angeschlossen. Mit den Leistungselektronik-Modulen ist es möglich, sowohl elektrische Energiequellen als auch elektrische Energiesenken nachzubilden. Dazu kann das Leistungselektronik-Modul über eine Schnittstelle so angesteuert werden, dass an seinem Lastanschluss eine bestimmte elektrischer Anschlussgröße eingestellt wird, also eine bestimmte Spannung oder ein bestimmter Strom.

Aus dem zuvor Gesagten ergibt sich, dass die beanspruchte Testanordnung das zu testende leistungselektronische Steuergerät selbst nicht umfasst, das zu testende leistungselektronische Steuergerät muss aber dem Wesen nach beschrieben werden, da ansonsten das Zusammenwirken der Komponenten der beanspruchten Testanordnung nicht verständlich ist. Wenn es heißt, dass im einsatzfähigen Zustand der Testanordnung die Speiseanschlüsse und/oder die Lastanschlüsse des Steuergeräts jeweils mit dem Lastanschluss eines Leistungselektronik-Moduls zur Bereitstellung einer gewünschten elektrischen Anschlussgröße an den Speiseanschlüssen und den Lastanschlüssen des Steuergeräts verbunden sind, dann ist damit erkennbar gemeint, dass zur Herstellung des einsatzfähigen Zustandes der Testanordnung eine Verbindung der von der Testanordnung umfassten Leistungselektronik-Module mit den entsprechenden Anschlüssen des nicht von der Testanordnung umfassten zu testenden leistungselektronischen Steuergeräts herzustellen ist; mithin sind die Lastanschlüsse der Leistungselektronik-Module mit den Speiseanschlüssen und/oder den Lastanschlüssen des zu testenden Steuergeräts verbindbar.

Wie das Leistungselektronik-Modul über seine Schnittstelle angesteuert werden muss, damit sich die gewünschte elektrische Anschlussgröße an seinem Lastanschluss einstellt, ergibt sich meist durch Berechnung entsprechender mathematischer Motormodelle und/oder Batteriemodelle auf einem HIL-Simulator. Dazu werden die realen elektrischen Anschlussgrößen messtechnisch erfasst, im Rahmen der mathematischen Modelle unter Berücksichtigung der modellmäßig gewünschten Anschlussgrößen weiterverarbeitet und entsprechende Steuersequenzen für die in den Leistungselektronik-Modulen enthaltenen Leistungsschalter berechnet und auf die Schnittstelle der Leistungselektronik-Module ausgegeben. Dieser Vorgang ist für die hier verfolgte Fragestellung nicht von Interesse, er ist teilweise zum Beispiel Gegenstand der europäischen Patentanmeldung mit Veröffentlichungsnummer EP 3316477 A1.

Die Verbindung der Speiseanschlüsse der Leistungselektronik-Module über das elektrische Zwischennetz hat den Vorteil, dass elektrische Energie zwischen den Leistungselektronik-Modulen ausgetauscht werden kann. Von extern muss in das elektrische Zwischennetz nur diejenige Energie nachgespeist werden, die von der Testanordnung und dem zu testenden leistungselektronischen Steuergerät dissipiert wird. Es kann also sein, dass zwischen den Leistungselektronik-Modulen über das Zwischennetz elektrische Ströme im Bereich von einigen 1000 A ausgetauscht werden, über eine an das Zwischennetz angeschlossene externe Energiequelle aber nur einige wenige Ampere nachgespeist werden müssen. Im Stand der Technik ist das elektrische Zwischennetz als Gleichstrom-Zwischennetz ausgelegt. Demnach sind auch die Speiseanschlüsse der Leistungselektronik-Module im Stand der Technik als Gleichstrom-Speiseanschlüsse ausgelegt (dSPACE GmbH: "Power Hardware-in-the-Loop Testing; Closing the gap between HIL and dynamometer testing", Produktkatalog, September 2021).

Bei der Verwendung eines Gleichstrom-Zwischennetzes hat es sich als aufwendig herausgestellt, wenn Komponenten in die Testanordnung integriert werden sollen, die keine Gleichstrom-Speisung an ihren Speiseanschlüssen aufweisen, sondern an ein Wechselstromnetz angeschlossen werden müssen. Dies kann beispielsweise der Fall sein, wenn die Vorgabe besteht, dass an das leistungselektronische Steuergerät speiseseitig oder lastseitig entsprechende wechselstromgespeiste Lasten (worunter auch Energiequellen, also beispielsweise wechselstromgespeiste Batterieemulatoren, verstanden werden können) eingesetzt werden sollen. Dann werden die wechselstromgespeisten Lasten direkt mit einem Wechselstromnetz verbunden, womit jedoch die Möglichkeit entfällt, diese Lasten mit dem Gleichstrom-Zwischennetz zu verbinden, wodurch der Energieaufwand für den Betrieb der Testanordnung erheblich ansteigen kann. Darüber hinaus werden zur Speisung des Gleichspannung-Zwischennetzes vollrückspeisefähige Netzteile mit Gleichwandler benötigt, was aufwendig ist und einen nicht unerheblichen Kostenfaktor darstellt.

Aufgabe der vorliegenden Erfindung ist es, eine Testanordnung zum Test eines leistungselektronischen Steuergeräts und ein Leistungselektronik-Modul für eine solche Testanordnung anzugeben, die die zuvor aufgezeigten Nachteile vermeidet.

Die zuvor hergeleitete Aufgabe ist bei der eingangs beschriebenen Testanordnung dadurch gelöst, dass die Speiseanschlüsse der Leistungselektronik-Module als Wechselstrom-Speiseanschlüsse ausgelegt sind, dass das elektrische Zwischennetz als Wechselstrom-Zwischennetz ausgelegt ist und dass die Versorgungsschaltung als eine Mehrphasenschaltung zur Bereitstellung mehrerer Phasenspannungen auf mehreren Phasenleitern ausgebildet ist, wobei die Auswahlschaltung mit den Leistungsschaltern zur Verbindung eines Phasenleiters mit dem Lastanschluss des Leistungselektronik-Moduls ausgebildet ist. Da die Speiseanschlüsse der Leistungselektronik-Module als Wechselstrom-Speiseanschlüsse ausgelegt sind, die Leistungselektronik-Module demzufolge also geeignet sind, mit Wechselstrom betrieben zu werden, ist es ohne Weiteres möglich, in die Testanordnung auch solche Geräte zu integrieren, für deren Betrieb eine Versorgung mit Wechselstrom erforderlich ist. Auf die Umgehung des Zwischennetzes kann verzichtet werden, die Nutzung des Zwischennetzes bleibt erhalten. Der zum Betrieb erforderliche Wechselstrom kann aus dem Wechselstrom-Zwischennetz bezogen werden. Wenn hier ausschließlich Wechselstrom genannt wird und nicht etwa Wechselspannung, dann ist das dem Umstand geschuldet, dass in der Fachliteratur von AC und DC (also Alternating Current bzw. Direct Current) Netzteilen/Geräten/Zwischennetzen gesprochen wird, also meist ein Bezug zum Strom hergestellt wird.

Bei einer bevorzugten Ausgestaltung der Testanordnung ist vorgesehen, dass das Wechselstrom-Zwischennetz über ein Verbindungsmittel mit einem externen Wechselstromnetz verbindbar ist. Mit dem externen Wechselstromnetz ist beispielsweise der Wechselstrom-Hausanschluss der Umgebung (des Labors) gemeint, in der die Testanordnung untergebracht ist. Das Verbindungsmittel kann einen Wechselstrom-Transformator (AC/AC) umfassen. Der Wechselstrom-Transformator kann für relativ geringe Leistungen ausgelegt sein, da die Komponenten der Testanordnung an das Wechselstrom-Zwischennetz angeschlossen sind und die Energieversorgung im Wesentlichen durch den Austausch von Energie über das Wechselstrom-Zwischennetz erfolgt und nur tatsächlich in der Testanordnung dissipierte Energie ersetzt werden muss. In einer bevorzugten Ausgestaltung ist das Wechselstrom-Zwischennetz dreiphasig ausgelegt.

Eine besonders vorteilhafte Weiterbildung der Testanordnung ist dadurch gekennzeichnet, dass das Leistungselektronik-Modul eine galvanische Trennung zwischen den Speiseanschlüssen und dem Lastanschluss des Leistungselektronik-Moduls aufweist, wobei die galvanische Trennung bevorzugt durch einen Transformator realisiert ist. Durch diese Maßnahme wird eine überraschende Vielzahl an vorteilhaften Eigenschaften erzielt.

Durch die galvanische Trennung hat der Lastanschluss des Leistungselektronik-Moduls kein festes Bezugspotenzial mehr, abgesehen natürlich zu dem elektrischen Potenzial auf einem immer vorhandenen weiteren Bezugs-Lastanschluss des Leistungselektronik-Moduls. Aber auch das elektrische Potenzial dieses weiteren Bezugs-Lastanschlusses des Leistungselektronik-Moduls ist potenzialmäßig frei gegenüber anderen Lastanschlüssen (einschließlich Bezugs-Lastanschlüssen) von weiteren Leistungselektronik-Modulen, die ebenfalls galvanische getrennt sind von ihren Speiseanschlüssen. Dadurch ist es beispielsweise möglich, die Lastanschlüsse verschiedener Leistungselektronik-Module in Reihe zu schalten, um beispielsweise eine höhere Spannung bereitzustellen. Darüber hinaus ist es auch vollkommen unproblematisch, die Lastanschlüsse mehrerer derartiger Leistungselektronik-Module an mehrere Speiseanschlüsse eines zu testenden Steuergeräts anzuschließen, wenn das Steuergerät beispielsweise vorsieht, mehrere Energiequellen zu nutzen. Es ist aufgrund der Potenzialfreiheit der Speiseanschlüsse verschiedener Leistungselektronik-Module nicht mehr wichtig, zu wissen, wie das zu testende Steuergerät diese verschiedenen Leistungselektronik-Module intern zusammenschaltet, die Lastanschlüsse der verschiedenen Leistungselektronik-Module in Serie schaltet oder auch parallel zusammenschaltet (oder Betriebspunktabhängig mal in Serie und mal parallel schaltet), weil eine tatsächliche Potenzialfreiheit auf der Seite der Lastanschlüsse der Leistungselektronik-Module gegeben ist. Die Leistungselektronik-Module verhalten sich diesbezüglich also wie "echte" Batterien, wie sie häufig im Falle der Serienanwendung von Steuergeräten verwendet werden. Ein weiterer Vorteil besteht darin, dass die Lastanschlüsse der hier betrachteten Leistungselektronik-Module auch mit weiteren Geräten zusammengeschaltet werden können, beispielsweise mit Netzteilen oder Signalgeneratoren zwecks Überlagerung von Stör- oder Nutzsignalen (zum Beispiel Rippelgenerator). Ein weiterer Vorteil der transformatorischen galvanische Trennung der Speiseanschlüsse eines Leistungselektronik-Moduls von den Lastanschlüssen dieses Leistungselektronik-Moduls besteht darin, dass eine hohe Gleichtaktunterdrückung zwischen Lastseite und Speiseseite des Leistungselektronik-Moduls bewirkt wird, sodass Gleichtaktstörungen sich nicht von den Lastanschlüssen des Leistungselektronik-Moduls auf die Speiseanschlüsse des Leistungselektronik-Moduls und damit in das Wechselstrom-Zwischennetzübertragen; dies gilt auch in umgekehrter Richtung.

Bei einer Ausgestaltung der Testanordnung bzw. der Leistungselektronik-Module ist vorgesehen, dass der Transformator des Leistungselektronik-Moduls speiseseitig dreiphasig und lastseitig mindestens dreiphasig ausgestaltet ist, insbesondere sechsphasig oder neunphasig ausgestaltet ist. Die Verwendung einer dreiphasigen Speisung des Leistungselektronik-Moduls hat den Vorteil, dass bereits mehrere voneinander abweichende elektrische Potenziale vorliegen, wobei zumindest diese drei verschiedenen elektrischen Potenziale auch lastseitig verwendet werden aufgrund der zumindest dreiphasigen Auslegung der Lastseite des Transformators. Wenn der Transformator lastseitig sogar sechs- oder neunphasig ausgestaltet ist, liegen zeitgleich sogar noch mehr unterschiedliche elektrische Potenziale vor. Dies ist insoweit vorteilhaft, da die zwischen dem lastseitigen Teil des Transformators und den Lastanschlüssen des Leistungselektronik-Moduls angeordneten Leistungsschalter der Auswahlschaltung viel feiner abgestuft zwischen verschiedenen elektrischen Potenzialen auswählen können, die dann bedarfsweise (und steuerbar über die Schnittstelle zur Ansteuerung der Leistungsschalter) zur Erzielung der entsprechenden gewünschten elektrischen Anschlussgröße auf den Lastanschluss des Leistungselektronik-Moduls geschaltet werden.

Eine Weiterentwicklung der Testanordnung bzw. der Leistungselektronik-Module zeichnet sich dadurch aus, dass die Leistungsschalter der Auswahlschaltung bidirektional sperrbare Leistungshalbleiter umfassen, insbesondere bidirektionale MOSFET-Schalter, bevorzugt auf Basis von Silizium-Karbid. Dazu werden zwei MOSFET-Schalter mit gegensinnig orientierten Freilaufdioden in Serie geschaltet, sodass Ströme in jeder Durchlaufungsrichtung sicher gesperrt werden können.

Die Erfindung betrifft ferner ein Leistungselektronik-Modul für eine Testanordnung zum Test eines leistungselektronischen Steuergeräts, wobei das Leistungselektronik-Modul Speiseanschlüsse zur Energiespeisung, wenigstens einen Lastanschluss zur Bereitstellung wenigstens einer elektrischen Anschlussgröße, eine Versorgungsschaltung zur Bereitstellung elektrischer Steuerspannungen, eine Auswahlschaltung mit Leistungsschaltern zur Aufschaltung einer der Steuerspannungen auf den Lastanschluss des Leistungselektronik-Moduls und eine Schnittstelle zur Ansteuerung der Leistungsschalter aufweist, wobei erfindungsgemäß vorgesehen ist, dass die Speiseanschlüsse des Leistungselektronik-Moduls als Wechselstrom-Speiseanschlüsse ausgelegt sind und dass die Versorgungsschaltung als eine Mehrphasenschaltung zur Bereitstellung mehrerer Phasenspannungen auf mehreren Phasenleitern ausgebildet ist, wobei die Auswahlschaltung mit den Leistungsschaltern zur Verbindung eines Phasenleiters mit dem Lastanschluss des Leistungselektronik-Moduls ausgebildet ist. Das Leistungselektronik-Modul zeichnet sich in weiteren Ausgestaltungen durch die Merkmale der Leistungselektronik-Module aus, die zuvor im Zusammenhang mit den Leistungselektronik-Modulen der Testanordnung beschrieben worden sind.

Im Einzelnen gibt es nun eine Vielzahl von Möglichkeiten, die erfindungsgemäße Testanordnung und das erfindungsgemäße Leistungselektronik-Modul auszugestalten und weiterzubilden. Dazu wird verwiesen einerseits auf die den unabhängigen Patentansprüchen nachgeordneten Patentansprüche, andererseits auf die folgende Beschreibung von Ausführungsbeispielen in Verbindung mit der Zeichnung. In der Zeichnung zeigen
- Fig. 1: eine Testanordnung zum Test eines leistungselektronischen Steuergeräts wie aus dem Stand der Technik bekannt,
- Fig. 2: eine erfindungsgemäße Testanordnung zum Test eines leistungselektronischen Steuergeräts mit Leistungselektronik-Modulen mit Wechselstrom-Speiseanschlüssen und Wechselstrom-Zwischennetz,
- Fig. 3: ein Ausführungsbeispiel für ein erfindungsgemäßes Leistungselektronik-Modul,
- Fig. 4: ein Ausführungsbeispiel für eine erfindungsgemäße Testanordnung mit mehreren Leistungselektroniken-Modulen gemäß Fig. 3,
- Fig. 5: ein Ausführungsbeispiel für eine Testanordnung mit Leistungselektronik-Modulen, deren Lastanschlüsse in Serie geschaltet sind und
- Fig. 6: eine Testanordnung mit mehreren Leistungselektronik-Modulen, die mit einem Steuergerät mit mehreren Speiseanschlüssen für mehrere Energiequellen ausgestattet ist.

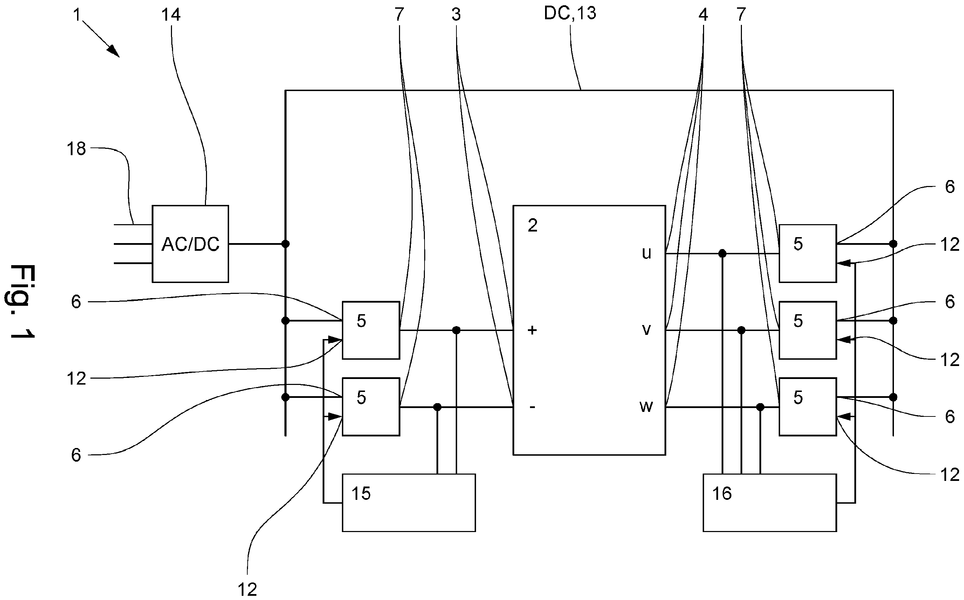

Fig. 1 zeigt eine Testanordnung 1 zum Test eines leistungselektronischen Steuergeräts 2, die aus dem Stand der Technik bekannt ist. Das Steuergerät 2 hat Speiseanschlüsse 3 zur Energiespeisung und Lastanschlüsse 4 zur Ansteuerung einer elektrischen Last. Die Testanordnung 1 weist eine Mehrzahl von Leistungselektronik-Modulen 5 auf, wobei jedes Leistungselektronik-Modul 5 Speiseanschlüsse 6 zur Energiespeisung, wenigstens einen Lastanschluss 7 zur Bereitstellung wenigstens einer elektrischen Anschlussgröße, eine Versorgungsschaltung zur Bereitstellung elektrischer Steuerspannungen, eine Auswahlschaltung mit Leistungsschaltern zur Aufschaltung einer der Steuerspannungen auf den Lastanschluss des Leistungselektronik-Moduls 5 und eine Schnittstelle 12 zur Ansteuerung der Leistungsschalter 11 aufweist.

Im einsatzfähigen Zustand der Testanordnung 1, wie in Fig. 1 dargestellt, sind die Speiseanschlüsse 3 und/oder die Lastanschlüsse 4 des Steuergeräts 2 jeweils mit dem Lastanschluss 7 eines Leistungselektronik-Moduls 5 zur Bereitstellung einer gewünschten Anschlussgröße an den Speiseanschlüssen 3 und den Lastanschlüssen 4 des Steuergeräts 2 verbunden. Die Speiseanschlüsse 6 der Leistungselektronik-Module 5 sind über ein elektrisches Zwischennetz 13 miteinander verbunden. Im Stand der Technik ist das elektrische Zwischennetz 13 ein Gleichstrom-Zwischennetz. Demzufolge sind im Stand der Technik die Speiseanschlüsse 6 der Leistungselektronik-Module 5 auch Gleichstrom-Speiseanschlüsse. Über das Zwischennetz 13 können die Leistungselektronik-Module 5 Energie austauschen, wodurch sich die Testanordnung 1 energiesparend betreiben lässt. Der in Fig. 1 dargestellten externe Netzanschluss 14 umfasst ein vollrückspeisefähiges Netzteil mit Gleichrichter (AC/DC) und kann über das Zwischennetz 13 Energie in die Testanordnung 1 einspeisen. Da Energie zwischen den Leistungselektronik-Modulen 5 über das Zwischennetz 13 ausgetauscht werden kann, muss über den externen Netzanschluss 14 nur ein kleiner Energieanteil nachgespeist werden, nämlich der Teil der Energie, der beim Betrieb der Testanordnung 1 dissipiert wird.

Die Testanordnung 1 simuliert die spätere Umgebung des zu testenden leistungselektronischen Steuergeräts 2. In dem dargestellten Ausführungsbeispiel wird sowohl die Energiespeisung durch die Leistungselektronik-Module 5 an den Speiseanschlüssen 3 des Steuergeräts 2 simuliert wie auch die Last an den Lastanschlüssen 4 des Steuergeräts 2, ebenfalls durch Leistungselektronik-Module 5, die mit ihren Lastanschlüssen 7 mit den Lastanschlüssen 4 des Steuergeräts 2 verbunden sind. In dem dargestellten Ausführungsbeispiel in Fig. 1 handelt es sich um ein Motorsteuergerät 2 für den automotiven Bereich. Die Energiespeisung erfolgt im realen Serieneinsatz des Steuergeräts 2 durch eine Batterie und die Last des Steuergeräts 2 besteht im Serieneinsatz aus einem Dreiphasen-Elektromotor, der sowohl motorisch als auch generatorisch betrieben werden kann. Folglich könnte also ein Energiefluss sowohl von den Speiseanschlüssen 3 zu den Lastanschlüssen 4 des Steuergeräts 2 erfolgen, wie auch von den Lastanschlüssen 4 zu den Speiseanschlüssen 3 des Steuergeräts 2.

In Fig. 1 ist nicht im Detail dargestellt, wie der interne Aufbau der Leistungselektronik-Module 5 realisiert ist. Die Leistungselektronik-Module 5 umfassen jedenfalls eine Auswahlschaltung mit Leistungsschaltern, die über die Schnittstelle 12 ansteuerbar sind. Durch entsprechende Ansteuerung der Leistungsschalter über die Schnittstelle 12 kann durch Aufschalten einer Steuerspannung der hier im Einzelnen nicht dargestellten Versorgungsschaltung auf den Lastanschluss 7 die gewünschte elektrische Anschlussgröße an dem Lastanschluss 7 des Leistungselektronik-Moduls 5 eingestellt werden. Wie die Leistungsschalter angesteuert werden müssen, ergibt sich aus der Berechnung eines mathematischen Modells der nachzubildenden Quellen und Lasten des Steuergeräts 2, wobei diese Modelle üblicherweise mittels eines Hardware-in-the-Loop-Simulators in Echtzeit berechnet werden. Schematisch dargestellt sind hier ein Batteriemodell 15 und ein Motormodell 16. Die tatsächlichen Anschlussgrößen an den Lastanschlüssen 7 der Leistungselektronik-Module 5 werden messtechnisch erfasst und unter Berücksichtigung der Sollvorgabe für die elektrische Anschlussgröße werden dann von den Modellen 15, 16 entsprechende Ansteuersequenzen für die Leistungsschalter der Auswahlschaltung berechnet. Wie genau dies geschieht, ist nicht Gegenstand der vorliegenden Erfindung und insoweit nicht weiter erläuterungsbedürftig, wichtig ist lediglich, dass die Möglichkeit besteht, über die Schnittstelle 12 einen entsprechenden Einfluss auf das Leistungselektronik-Modul 5 zu nehmen.

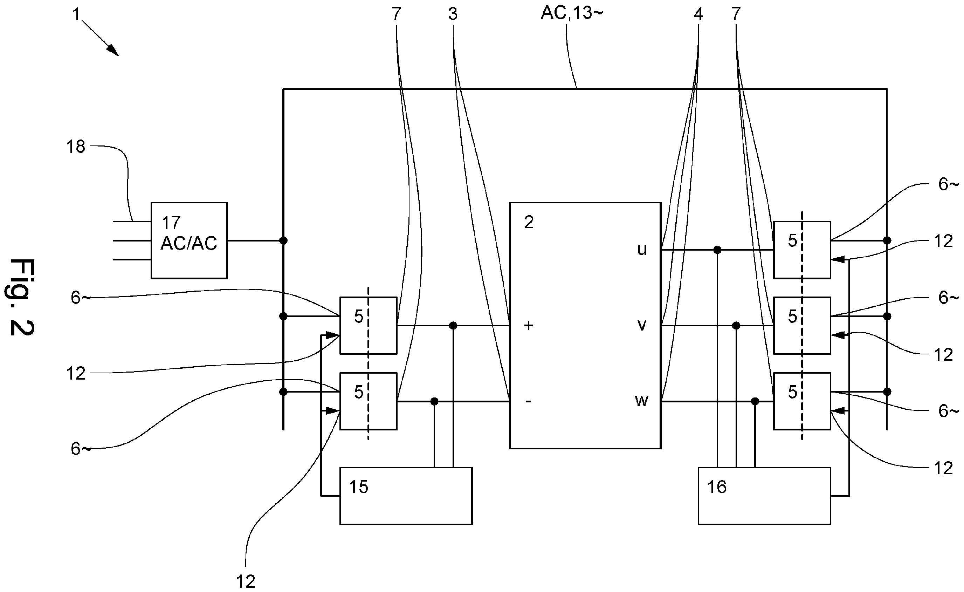

Problematisch bei der Testanordnung gemäß Fig. 1 ist die Situation, wenn auch Leistungselektronik-Module zum Einsatz kommen sollen, die über Wechselstrom gespeist werden müssen. In diesem Fall müssen diese Leistungselektronik-Module über das externe Wechselstromnetz gespeist werden, sie können nicht über das Gleichstrom-Zwischennetz 13 eingebunden werden. Dies erhöht insgesamt die Netzbelastung. Dadurch kann es auch erforderlich werden, dass der externe Netzanschluss 14 mit Gleichrichter, der auch rückspeisefähig sein muss, größer auszulegen ist. Dies ist aufwendig und kostspielig. Das zuvor geschilderte Problem wird mit den in den Fig. 2 bis 6 - zumindest teilweise - dargestellten Testanordnungen 1 und leistungselektronischen Modulen 5 gelöst.

Den Testanordnungen 1 in den Fig. 2 bis 6 ist gemein, dass die Speiseanschlüsse 6 der Leistungselektronik-Module 5 als Wechselstrom-Speiseanschlüsse 6~ ausgelegt sind und dass das elektrische Zwischennetz 13 als Wechselstrom-Zwischennetz 13- ausgelegt ist. Ferner ist die Versorgungsschaltung als eine Mehrphasenschaltung 8 zur Bereitstellung mehrerer Phasenspannungen auf mehreren Phasenleitern 9 ausgebildet ist, wobei die Auswahlschaltung 10 mit den Leistungsschaltern 11 zur Verbindung eines Phasenleiters 9 mit dem Lastanschluss 7 des Leistungselektronik-Moduls 5 ausgebildet. Die Leistungselektronik-Module 5 werden also grundsätzlich durch Wechselstrom gespeist und der Energieaustausch zwischen den Leistungselektronik-Modulen 5, die mit ihren Speiseanschlüssen 6 über das Wechselstrom-Zwischennetz 13 verbunden sind, tauschen Energie demgemäß in Form von Wechselstrom miteinander aus.

Wenn in Zusammenhang mit den Ausführungsbeispielen in den Fig. 2 bis 6 von den Speiseanschlüssen 6 der Leistungselektronik-Module gesprochen wird, dann sind also stets Wechselstrom-Speiseanschlüsse 6~ gemeint, und wenn von dem elektrischen Zwischennetz 13 gesprochen wird, ist stets ein Wechselstrom-Zwischennetz 13- gemeint.

Die beschriebene Auslegung der Testanordnung 1 hat den Vorteil, dass ohne Weiteres auch solche Leistungselektronik-Module 5 in die Testanordnung 1 unter Nutzung des Zwischennetzes 13 integriert werden können, die speiseseitig mit elektrischen Wechselgrößen zu versorgen sind. Derartige Leistungselektronik-Module 5 müssen nun nicht mehr von dem Zwischennetz 13 entkoppelt werden und über einen externen Netzanschluss versorgt werden. Die Möglichkeit des Energieaustausches über das Zwischennetz 13 bleibt vollständig erhalten.

Bei den Ausführungsbeispielen gemäß den Fig. 2, 5 und 6 ist das Wechselstrom-Zwischennetz 13- über ein Verbindungsmittel 17 mit einem externen Wechselstromnetz 18 verbindbar, wobei das Verbindungsmittel 17 hier ein einfacher Transformator ohne Gleichrichter ist (AC/AC). Bei Betrieb der Testanordnung 1 gemäß den Fig. 2 bis 6 muss über das Verbindungsmittel 17 lediglich die Energie nachgeliefert werden, die bei Betrieb der Testanordnung 1 durch die Elemente der Testanordnung 1 dissipiert wird. Ferner ist allen Ausführungsbeispielen der Fig. 2 bis 6 für die Testanordnung 1 und auch für die Leistungselektronik-Module 5 gemeinsam, dass das Wechselstrom-Zwischennetz 13∼ dreiphasig ist und entsprechend die Speiseanschlüsse 6 der Leistungselektronik-Module 5 dreiphasig ausgelegt sind.

Von besonderem Vorteil ist, dass die in den Fig. 2 bis 6 dargestellten Leistungselektronik-Module 5 eine galvanische Trennung zwischen den Speiseanschlüssen 6 und den Lastanschlüssen 7 der Leistungselektronik-Module 5 aufweisen (angedeutet durch die vertikale gestrichelte Linie in den Fig. 2, 5 und 6). Technisch wird die galvanische Trennung jeweils durch einen Transformator 19 realisiert. Hieraus ergeben sich eine Vielzahl von Vorteilen. Dadurch, dass der Lastanschluss 7 aufgrund der galvanischen Trennung hinsichtlich des Speiseanschlusses 6 potenzialfrei ist, können die Lastanschlüsse 7 verschiedener Leistungselektronik-Module 5 miteinander verschaltet werden. Auch können zusätzliche Geräte an die Lastanschlüsse 7 der Leistungselektronik-Module 5 geschaltet werden, beispielsweise Signalgeneratoren zur Aufbringung von überlagerten Störsignalen. Durch die Realisierung der galvanischen Trennung mit dem Transformator 19 wird zwischen der Speiseseite und der Lastseite des Leistungselektronik-Moduls 5 eine hohe Gleichtaktunterdrückung bewirkt, sodass Gleichtaktfehler nicht - oder nur stark gedämpft - von der Lastseite auf die Speiseseite und umgekehrt übertragen werden.

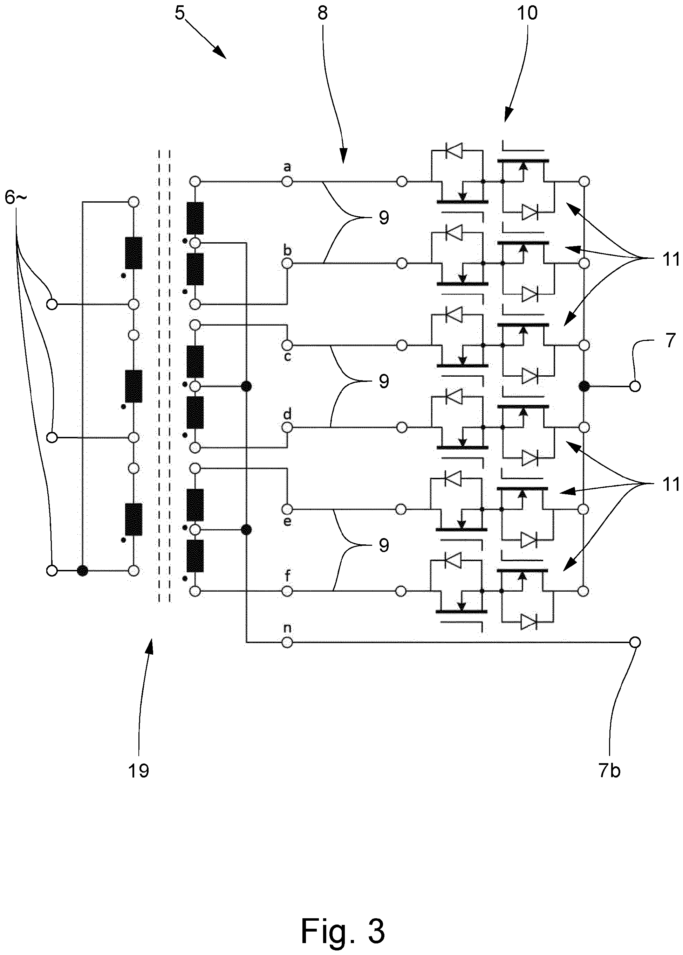

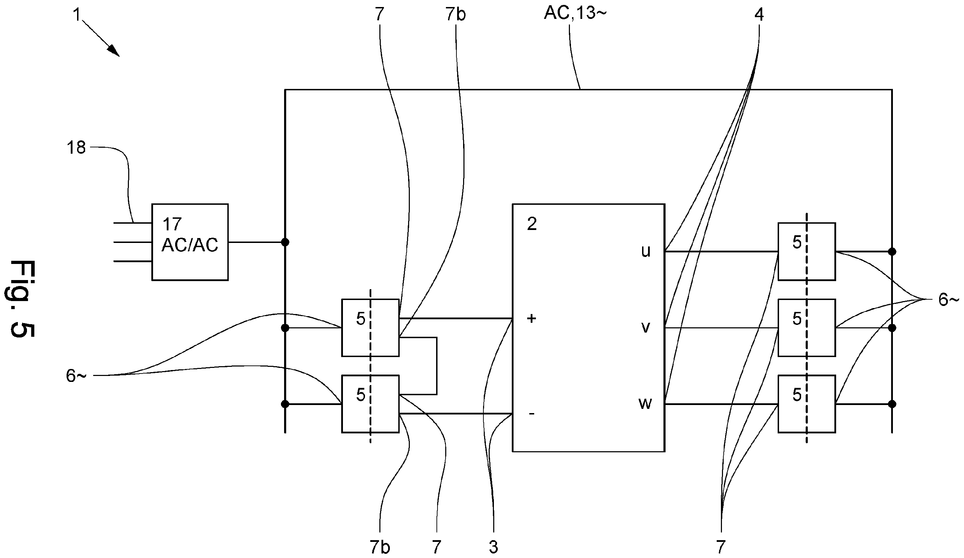

Wie aus Fig. 3 ersichtlich ist, ist der Transformator 19 als 3-auf-6-Phasen-Transformator realisiert, wobei die Speiseseite mit drei in Dreieck geschalteten Spulen umgesetzt ist und wobei die Lastseite mit sechs Spulen in Sternschaltung realisiert ist. Die sechs Spulen ergeben sich funktional aus drei Spulen mit Mittenabgriff. Der Vorteil einer größeren Phasenanzahl auf der Lastseite liegt darin, dass gleichzeitig auch eine größere Anzahl von Phasenspannungen auf den Phasenleitern 9 der Mehrphasenschaltung 8 zur Verfügung stehen. Die Phasenspannungen sind aufgrund der größeren Anzahl untereinander potenzialmäßig feiner abgestuft. Die Phasenspannungen können dann durch Betätigen der Leistungsschalter 11 der Auswahlschaltung 10 auf den Lastanschluss 7 des Leistungselektronik-Moduls 5 geschaltet werden. In Fig. 5 ist die Schnittstelle zur Ansteuerung der Leistungsschalter 11 aus Gründen der Übersichtlichkeit nicht im Einzelnen dargestellt. Die Leistungsschalter 11 der Auswahlschaltung 10 sind hier bidirektional sperrbare Leistungshalbleiter, nämlich bidirektionale MOSFET-Schalter auf Basis von Silizium-Karbid. Es versteht sich von selbst, dass die Schnittstelle 12 zur Ansteuerung der Leistungsschalter 11 entsprechende Steuerleitungen umfasst, die mit den Gate-Anschlüssen der MOSFET-Schalter verbunden sind.

Aus Fig. 3 ist ferner ersichtlich, dass der Sternpunkt der lastseitig in Sternschaltung zusammengeschalteten Spulen als weiterer Lastanschluss, nämlich als Bezugs-Lastanschluss 7b des Leistungselektronik-Moduls 5 verfügbar gemacht wird. Das Herausführen eines solchen Bezugs-Lastanschluss 7b aus dem Leistungselektronik-Modul 5 ist im Grunde immer erforderlich, da das elektrische Potenzial an dem Lastanschluss 7 immer nur in Bezug zu einem Bezugspotenzial eingestellt werden muss. Damit genau dieses Potenzialgefälle auch wirksam werden kann, muss das Bezugspotenzial schaltungstechnisch verfügbar gemacht werden, hier durch den Bezugs-Lastanschluss 7b.

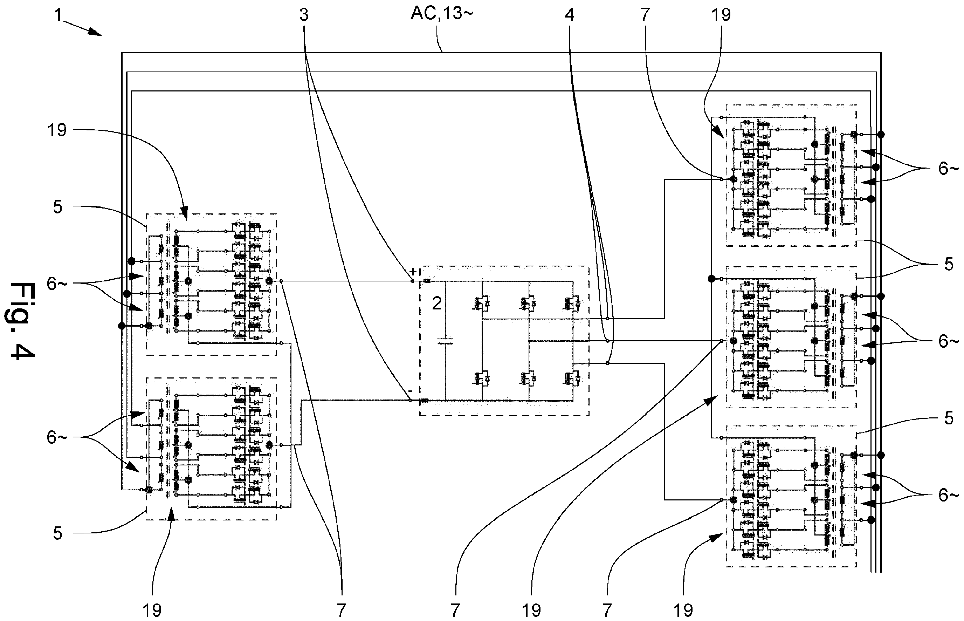

In Fig. 4 ist nochmals eine Testanordnung 1 mit Leistungselektronik-Modulen 5 dargestellt, die den Leistungselektronik-Modulen 5 gemäß Fig. 3 entsprechen. Sämtliche leistungselektronische Anschlüsse, also die Speiseanschlüsse 3 und die Lastanschlüsse 4 des zu testenden Steuergeräts 2, werden hier über Leistungselektronik-Module 5 gespeist bzw. belastet. Wie eingangs erwähnt, gehört das zu testende leistungselektronische Steuergerät 2 nicht zu der beanspruchten Testanordnung 1, die Steuergeräte 2 sind dargestellt, um die Funktionsweise der Testanordnung 1 besser erläutern zu können.

Bei dem Ausführungsbeispiel gemäß Fig. 5 ist ein vorteilhafter Anwendungsfall der Leistungselektronik-Module 5 mit galvanischer Trennung dargestellt. In dem Ausführungsbeispiel ist es ohne Weiteres möglich, zwei Leistungselektronik-Module 5 in Serie zu schalten, um eine höhere Ausgangsspannung zu bewirken. Die Lastanschlüsse 7 bzw. Bezugs-Lastanschlüsse 7b können hier ohne Weiteres miteinander verbunden werden, da die Lastanschlüsse 7, 7b eines jeden Leistungselektronik-Moduls 5 hinsichtlich der Lastanschlüsse 7, 7b eines anderen Leistungselektronik-Moduls 5 potenzialmäßig frei sind.

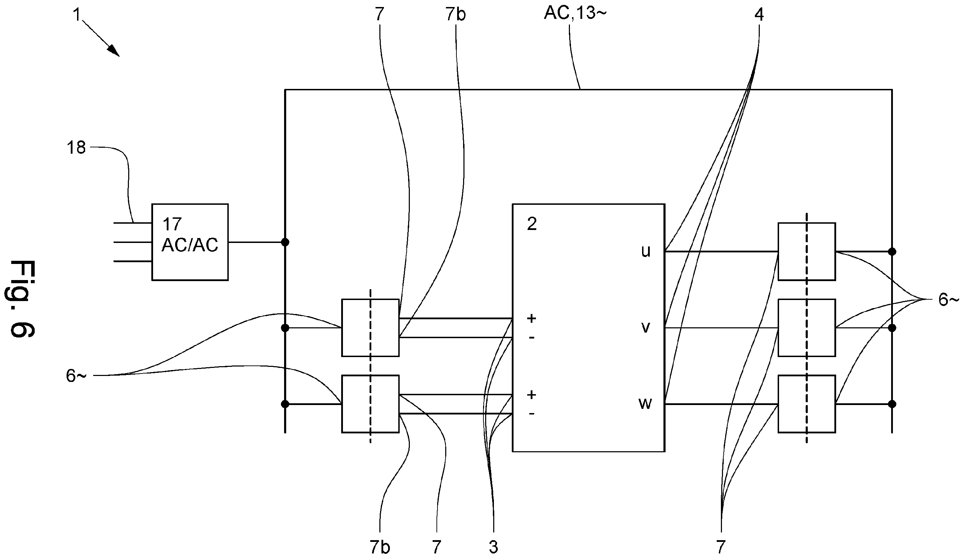

Ein weiterer vorteilhafter Anwendungsfall ist in Fig. 6 dargestellt. Hier weist ein zu testendes Steuergerät 2 zwei Paare von Lastanschlüssen 3 zum Anschließen zweier Energiequellen (im Serienanwendungsfall Batterien) auf. Intern schaltet das Steuergerät 2 die beiden Energiequellen je nach Belastungszustand wahlweise in Serie oder auch parallel. Wenn in dieser Situation Leistungselektronik-Module zum Einsatz kämen, die potenzialmäßig beispielsweise einen festen Bezug zu den Spannungen des Zwischennetzes 13~ hätten, dann könnten diese Leistungselektronik-Module nicht einfach an die Speiseanschlüsse 3 des Steuergerätes 2 angeschlossen werden. Da in dem dargestellten Ausführungsbeispiel die zur Anwendung kommenden Leistungselektronik-Module 5 aber eine galvanische Trennung aufweisen, ist der Einsatz dieser Leistungselektronik-Module 5 in dem dargestellten Anwendungsfall vollkommen unproblematisch.

### Bezugszeichen

- 1: Testanordnung
- 2: leistungselektronisches Steuergerät
- 3: Speiseanschlüsse des Steuergeräts
- 4: Lastanschlüsse des Steuergeräts
- 5: Leistungselektronik-Modul
- 6: Speiseanschlüsse des Leistungselektronik-Moduls
- 6~: Wechselstrom-Speiseanschlüsse des Leistungselektronik-Moduls
- 7: Lastanschlüsse des Leistungselektronik-Moduls
- 7b: Bezugs-Lastanschluss des Leistungselektronik-Moduls
- 8: Mehrphasenschaltung
- 9: Phasenleiter
- 10: Auswahlschaltung mit Leistungsschaltern
- 11: Leistungsschalter
- 12: Schnittstelle zur Ansteuerung der Leistungsschalter
- 13: elektrisches Zwischennetz
- 13∼: Wechselstrom-Zwischennetz
- 14: Netzanschluss mit vollrückspeisefähigem Netzteil mit Gleichrichter (AC/DC)
- 15: Batteriemodell
- 16: Motormodell
- 17: Verbindungsmittel mit Transformator (AC/AC)
- 18: Externes Wechselstromnetz
- 19: Transformator zur galvanischen Trennung

## Patentansprüche

1. Testanordnung (1) zum Test eines leistungselektronischen Steuergeräts (2), wobei das Steuergerät (2) Speiseanschlüsse (3) zur Energiespeisung und Lastanschlüsse (4) zur Ansteuerung einer elektrischen Last aufweist, mit einer Mehrzahl von Leistungselektronik-Modulen (5), wobei jedes Leistungselektronik-Modul (5) Speiseanschlüsse (6) zur Energiespeisung, wenigstens einen Lastanschluss (7) zur Bereitstellung wenigstens einer elektrischer Anschlussgröße, eine Versorgungsschaltung zur Bereitstellung elektrischer Steuerspannungen, eine Auswahlschaltung (10) mit Leistungsschaltern (11) zur Aufschaltung einer der Steuerspannungen auf den Lastanschluss (7) des Leistungselektronik-Moduls (5) und eine Schnittstelle (12) zur Ansteuerung der Leistungsschalter (11) aufweist, wobei im einsatzfähigen Zustand der Testanordnung (1) die Speiseanschlüsse (3) und/oder die Lastanschlüsse (4) des Steuergeräts (2) jeweils mit dem Lastanschluss (7) eines Leistungselektronik-Moduls (5) zur Bereitstellung einer gewünschten elektrischen Anschlussgröße an den Speiseanschlüssen (3) und/oder den Lastanschlüssen (4) des Steuergeräts (2) verbunden sind und wobei die Speiseanschlüsse (6) der Leistungselektronik-Module (5) über ein elektrisches Zwischennetz (13) miteinander verbunden sind,
**dadurch gekennzeichnet,**
**dass** die Speiseanschlüsse (6) der Leistungselektronik-Module als Wechselstrom-Speiseanschlüsse (6~) ausgelegt sind, dass das elektrische Zwischennetz (13) als Wechselstrom-Zwischennetz (13∼) ausgelegt ist und dass die Versorgungsschaltung als eine Mehrphasenschaltung (8) zur Bereitstellung mehrerer Phasenspannungen auf mehreren Phasenleitern (9) ausgebildet ist, wobei die Auswahlschaltung (10) mit den Leistungsschaltern (11) zur Verbindung eines Phasenleiters (9) mit dem Lastanschluss (7) des Leistungselektronik-Moduls (5) ausgebildet ist.

2. Testanordnung (1) nach Anspruch 1, **dadurch gekennzeichnet, dass** das Wechselstrom-Zwischennetz (13~) über ein Verbindungsmittel (17) mit einem externen Wechselstromnetz (18) verbindbar ist.

3. Testanordnung (1) nach Anspruch 1 oder 2, **dadurch gekennzeichnet, dass** das Wechselstrom-Zwischennetz (13~) dreiphasig ist.

4. Testanordnung (1) nach einem der Ansprüche 1 bis 3, **dadurch gekennzeichnet, dass** das Leistungselektronik-Modul (5) eine galvanische Trennung zwischen den Speiseanschlüssen (6) und dem Lastanschluss (7) des Leistungselektronik-Moduls (5) aufweist.

5. Testanordnung (1) nach Anspruch 4, **dadurch gekennzeichnet, dass** die galvanische Trennung durch einen Transformator (19) realisiert ist.

6. Testanordnung (1) nach Anspruch 5, **dadurch gekennzeichnet, dass** der Transformator (19) speiseseitig dreiphasig und lastseitig mindestens dreiphasig ausgestaltet ist, insbesondere lastseitig sechsphasig oder neunphasig ausgestaltet ist.

7. Testanordnung (1) nach Anspruch 6, **dadurch gekennzeichnet, dass** der Transformator (19) als 3-auf-6-Phasen-Transformator realisiert ist, wobei die Speiseseite mit drei in Dreieck geschalteten Spulen realisiert ist, wobei die Lastseite mit sechs Spulen in Sternschaltung realisiert ist.

8. Testanordnung (1) nach einem der Ansprüche 1 bis 7, **dadurch gekennzeichnet, dass** die Leistungsschalter (11) der Auswahlschaltung (10) bidirektional sperrbare Leistungshalbleiter umfassen, insbesondere bidirektionale MOSFET-Schalter, bevorzugt auf Basis von Silizium-Karbid.

9. Leistungselektronik-Modul (5) für eine Testanordnung (1) zum Test eines leistungselektronischen Steuergeräts (2), mit Speiseanschlüssen (6) zur Energiespeisung, mit wenigstens einem Lastanschluss (7) zur Bereitstellung wenigstens einer elektrischen Anschlussgröße, mit einer Versorgungsschaltung zur Bereitstellung elektrischer Steuerspannungen, mit einer Auswahlschaltung (10) mit Leistungsschaltern (11) zur Aufschaltung einer der Steuerspannungen auf den Lastanschluss (7) des Leistungselektronik-Moduls (5) und mit einer Schnittstelle (12) zur Ansteuerung der Leistungsschalter (11),
**dadurch gekennzeichnet,**
**dass** die Speiseanschlüsse (6) des Leistungselektronik-Moduls (5) als Wechselstrom-Speiseanschlüsse (6~) ausgelegt sind und dass die Versorgungsschaltung als eine Mehrphasenschaltung (8) zur Bereitstellung mehrerer Phasenspannungen auf mehreren Phasenleitern (9) ausgebildet ist, wobei die Auswahlschaltung (10) mit den Leistungsschaltern (11) zur Verbindung eines Phasenleiters (9) mit dem Lastanschluss (7) des Leistungselektronik-Moduls (5) ausgebildet ist.

10. Leistungselektronik-Modul (5) nach Anspruch 9, **gekennzeichnet durch** die Merkmale des Kennzeichnungsteils wenigstens eines Anspruchs der Ansprüche 4 bis 8.
